Europäisches Patentamt

**European Patent Office**

Office européen des brevets

(11) Veröffentlichungsnummer: **0 059 462**
**B1**

(12) **EUROPÄISCHE PATENTSCHRIFT**

(45) Veröffentlichungstag der Patentschrift:
02.10.85

(21) Anmeldenummer: 82101521.1

(22) Anmeldetag: 27.02.82

(51) Int. Cl.⁴: **H 01 R 23/72, H 01 R 23/68**

(54) Einpressstift.

(30) Priorität: 02.03.81 DE 3107906
13.05.81 EP 81103663

(43) Veröffentlichungstag der Anmeldung:
08.09.82 Patentblatt 82/36

(45) Bekanntmachung des Hinweises auf die Patenterteilung:
02.10.85 Patentblatt 85/40

(84) Benannte Vertragsstaaten:
AT BE CH DE FR GB IT LI NL SE

(56) Entgegenhaltungen:
EP - A - 0 005 356
DE - A - 3 006 437
US - A - 4 155 321
US - A - 4 223 970

ELEKTROTECHNIK, Band 63, Nr. 3, 16. Februar 1981,
Würzburg

(73) Patentinhaber: Thaler, Hartmuth F., Ing. grad., Hohe
Strasse 15, D-7110 Öhringen (DE)

(72) Erfinder: Thaler, Hartmuth F., Ing. grad., Hohe
Strasse 15, D-7110 Öhringen (DE)

(74) Vertreter: Charrier, Rolf, Dipl.-Ing.,
Postfach 260 Rehlingenstrasse 8,
D-8900 Augsburg 31 (DE)

## Beschreibung

Die Erfindung betrifft einen Einpreßstift zum Herstellen einer lötfreien Verbindung mit der metallisierten Bohrung mindestens einer Leiterplatte, wobei die Einpreßzone des Stiftes zwei äußere Bereiche aufweist, die in Kontakt mit der Bohrungswandung kommen und die über einen Steg miteinander verbunden sind, welcher beim Einpressen des Stiftes in die Bohrung deformiert wird.

Es sind Einpreßstifte bekannt, deren Einpreßzone im Querschnitt quadratisch oder rechteckig ist. Wird ein solcher Einpreßstift in die metallisierte Bohrung einer Leiterplatte eingesetzt, dann dringen die äußeren Kanten der Einpreßzone in die Zinnschicht der Bohrungswandung ein. Da die Bohrungsdurchmesser und auch die Querschnittsabmessungen der Einpreßzone des Stiftes variieren, ist eine sichere Kontaktierung nicht immer erreichbar. Dies gilt insbesondere, wenn ein derartiger Einpreßstift durch die Bohrungen mehrerer hintereinander angeordneter Leiterplatten geführt ist. Hinzu kommt, daß die Einpreßstifte, welche durch die Bohrungen mehrerer hintereinander angeordneter Leiterplatten geführt sind, gleichzeitig die Aufgabe haben, die Leiterplatten mechanisch zusammenzuhalten, was dann bei den vorerwähnten Maßabweichungen nicht mehr gewährleistet ist.

Es sind sogenannte AMP-Einpreßstifte bekannt, bei denen die Einpreßzone zwei balkenförmige, parallel verlaufende Bereiche aufweist, welche voneinander getrennt sind und welche sich in der Mitte teilweise überlappen. Beim Einpressen eines solchen Stiftes in die Bohrung einer Leiterplatte verschieben sich die balkenförmigen Bereiche relativ zueinander. Auf diese Weise können relativ große Toleranzen der Bohrung und der Einpreßzone ausgeglichen werden. Nachteilig ist, daß nur zwei äußere, einander diagonal gegenüberliegende Kanten der Einpreßzone in Kontakt mit der Bohrungswandung stehen. Da jeder balkenförmige Bereich sich in Form eines beidseits eingespannten Trägers in Richtung der Stiftachse gesehen durchbiegt, ist es auch hier problematisch, die Kontaktierung und mechanische Verbindung bei mehreren hintereinander angeordneten Leiterplatten vorzunehmen, insbesondere da die Durchbiegefähigkeit der balkenförmigen Bereiche längs der Stiftachse unterschiedlich ist.

Bei einer weiteren bekannten Ausführungsform eines Einpreßstiftes besteht die Einpreßzone aus einem in Längsrichtung geschlitzten Rohr. Beim Einpressen eines solchen Stiftes in die Bohrung einer Leiterplatte biegen sich die kreisbogenförmigen Teile der Einpreßzone nach innen. Zwischen der Bohrungswandung und der Einpreßzone herrscht im wesentlichen ein Flächenkontakt. Hierdurch kann der Übergangswiderstand zwischen Stift und Bohrungswandung beeinträchtigt werden, wenn die Bohrungswandung und/oder die Einpreßzone eine Schicht erhöhten ohmschen Widerstands aufweist. Die Zinnschicht der Bohrungswandung wird nämlich durch keine Kanten der Einpreßzone durchdrungen. Auch hierbei tritt der vorerwähnte Nachteil auf, daß die elektrische und/oder mechanische Verbindung mehrerer hintereinander angeordneter Leiterplatten durch derartige Einpreßstifte nicht immer gewährleistet ist.

Es besteht die Aufgabe, den Einpreßstift so auszubilden, daß bei Toleranzabweichungen der Bohrungen und/oder der Einpreßzone stets eine einwandfreie elektrische und mechanische Verbindung zwischen Stift und Leiterplatte gewährleistet ist. Diese einwandfreie elektrische und mechanische Verbindung soll auch gewährleistet sein bei mehreren hintereinander angeordneten Leiterplatten, welche durch die Einpreßstifte miteinander verbunden sind.

Der EP-A-5 356 ist ein Einpreßstift zu entnehmen, dessen äußere Bereiche dick und nicht deformierbar ausgebildet sind, wobei die Außenkontur dieser Bereiche der Innenkontur der Bohrung entspricht, d. h. diese Außenkontur besteht aus Kreisbögen. Diese äußeren Bereiche sind durch einen dünnen Steg miteinander verbunden. Wird ein solcher Stift in eine Bohrung eingesetzt, dann wird der Steg plastisch deformiert und/oder abgeschert. Die Außenkontur der äußeren Bereiche liegt gegen die Bohrungswandung an. Hierdurch wird die Zinnschicht der Bohrungswand nicht durchdrungen, was zu dem vorerwähnten Nachteil führt. Insbesondere nachteilig ist die völlige plastische Deformation oder gar das Abscheren des Steges, der hierdurch die Elastizität verliert, die notwendig ist, um nach dem Einsetzen des Stiftes, in die Bohrung die Außenkontur der äußeren Bereiche sicher gegen die Bohrungswand pressen zu können. Dieser Nachteil tritt besonders bei einer mechanischen Belastung des Stiftes in Erscheinung, insbesondere wenn Rüttelbeanspruchungen auftreten. Auch ist dieser Einpreßstift ungeeignet, über die jeweiligen Bohrungen zwei oder mehr Leiterplatten miteinander verbinden zu können. Wird der Stift durch die Bohrung der ersten Leiterplatte geführt, dann wird der Steg der durch diese Bohrung geführten Einpreßzone bereits völlig plastisch deformiert oder abgeschert, so daß diese Einpreßzone in der Bohrung der zweiten Leiterplatte keinen Halt mehr findet, außer diese Bohrung der zweiten Leiterplatte würde einen Durchmesser aufweisen, der geringer ist als der Durchmesser der Bohrung der ersten Leiterplatte.

Gelöst wird diese Aufgabe mit den Merkmalen des Anspruches 1.

Vorteilhafte Ausgestaltungen sind den abhängigen Ansprüchen entnehmbar.

Der die äußeren schenkelförmigen Bereiche verbindende dünne Steg wird beim Einsetzen des Einpreßstiftes in eine Bohrung einer Leiterplatte vorzugsweise elastisch und nur bei sehr engen Bohrungsdurchmessern zum Teil plastisch verformt. Die äußeren schenkelförmigen Bereiche sind elastisch deformierbar. Es wird jedoch stets erreicht, daß die äußeren Kanten dieser Bereiche die Zinnschicht der Bohrungswandung durchdringen und in Berührung mit der Kupferwandung der Bohrung treten. Es entstehen auf diese Weise vier gasdichte, vibrationsfeste Kontaktierungszonen. Bei engen Bohrungsdurchmessern werden die äußeren schenkelförmigen Bereiche elastisch deformiert und nehmen in Extremfällen eine Außenkontur an, die nahezu der Innenkontur der Bohrungswand entspricht. Durch eine elastische Deformierbarkeit des dünnen Stegs und der äußeren Bereiche sind auch einwandfreie Verbindungen zwischen den Bohrungen von hintereinander angeordneten Leiterplatten und dem Stift herstellbar, da die Einpreßzone bei jeder Bohrung sich individuell den Verhältnissen in dieser Bohrung anpaßt.

Ausführungsbeispiele werden nachfolgend anhand der Zeichnungen näher erläutert. Es zeigt

Fig. 1 zwei als Federkontakte ausgebildete Einpreßstifte in ihrem Ausgangszustand;

Fig. 2 einen Einpreßstift nach Fig. 1 beim Einführen der Einpreßzone des Stiftes in die Bohrung einer Leiterplatte;

Fig. 3 einen in die Leiterplatte eingesetzten Einpreßstift;

Fig. 4 einen Schnitt durch die Einpreßzone;

Fig. 5 eine Seitenansicht der Einpreßzone nach Fig. 4,

Fig. 6 einen Schnitt durch die Nennmaß aufweisende Bohrung einer Leiterplatte mit einem darin eingesetzten Einpreßstift nach den Fig. 4 und 5;

Fig. 7 einen Schnitt durch die Einpreßzone bei einem weiteren Ausführungsbeispiel;

Fig. 8 einen Schnitt entsprechend Fig. 6 bei einer Übermaß aufweisenden Bohrung und bei einer Einpreßzone nach Fig. 7;

Fig. 9 einen Schnitt entsprechend Fig. 8 bei einer Untermaß aufweisenden Bohrung und

Fig. 10 einen Schnitt bei einer dritten Ausführungsform.

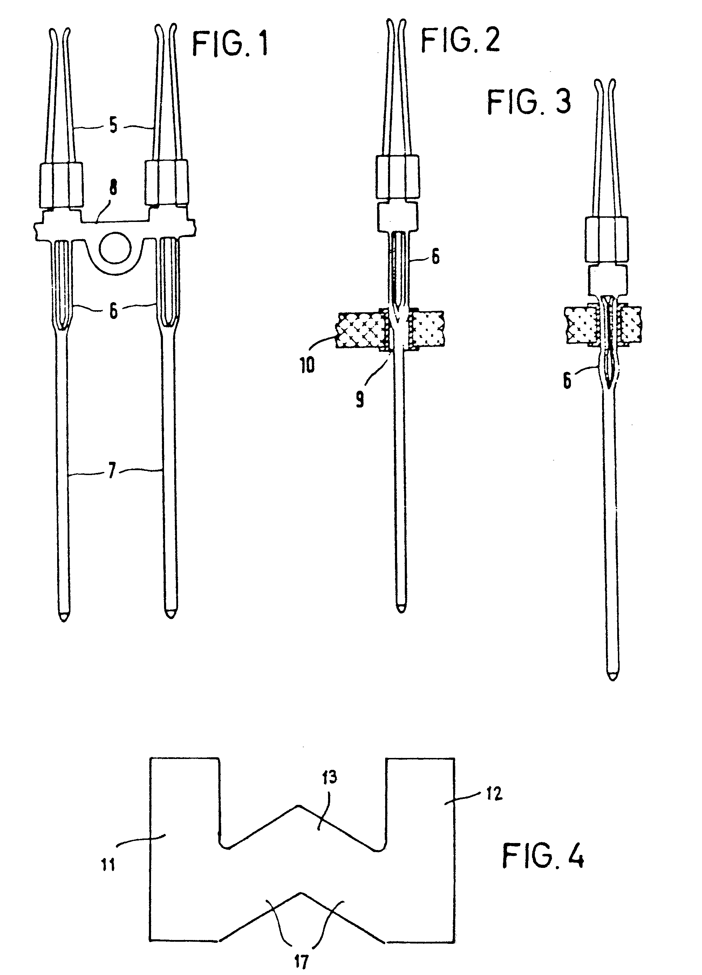

Die Einpreßstifte gemäß Fig. 1 weisen oberseitig einen Federkontakt 5 auf. Nach unten schließt sich eine Einpreßzone 6 an. Diese Einpreßzone 6 geht über in den üblichen Wire-Wrap-Pfosten 7.

Die Einpreßstifte werden aus einem Bandmaterial durch Ausstanzen hergestellt. Die Einpreßzone 6 wird geprägt und anschließend das aus Bandmaterial 8 bestehende Verbindungsstück, welches eine Positionierbohrung aufweist, abgetrennt.

Ein solcher Einpreßstift kann nunmehr in die Bohrung 9 einer Leiterplatte 10 eingesetzt werden. Wie der Fig. 2 entnehmbar ist, wird die Einpreßzone 6 beim Einpressen in die Bohrung 9 deformiert. Ein Vergleich der Fig. 2 und Fig. 3 zeigt, daß bei eingepreßtem Stift die Einpreßzone 6 elastisch deformiert wurde, wie die Aufbauchung unterhalb der Bohrung 6 in Fig. 3 zeigt.

Eine erste Querschnittsform der Einpreßzone ist in Fig. 4 gezeigt. Die Einpreßzone weist einen im wesentlichen M-förmigen Querschnitt auf. Sie besteht aus zwei äußeren im wesentlichen schenkelförmigen, parallel verlaufenden Bereichen 11, 12. Diese beiden Bereiche 11, 12 sind über einen Steg 13 miteinander verbunden. Dieser Steg 13 ist im wesentlichen V-förmig ausgebildet.

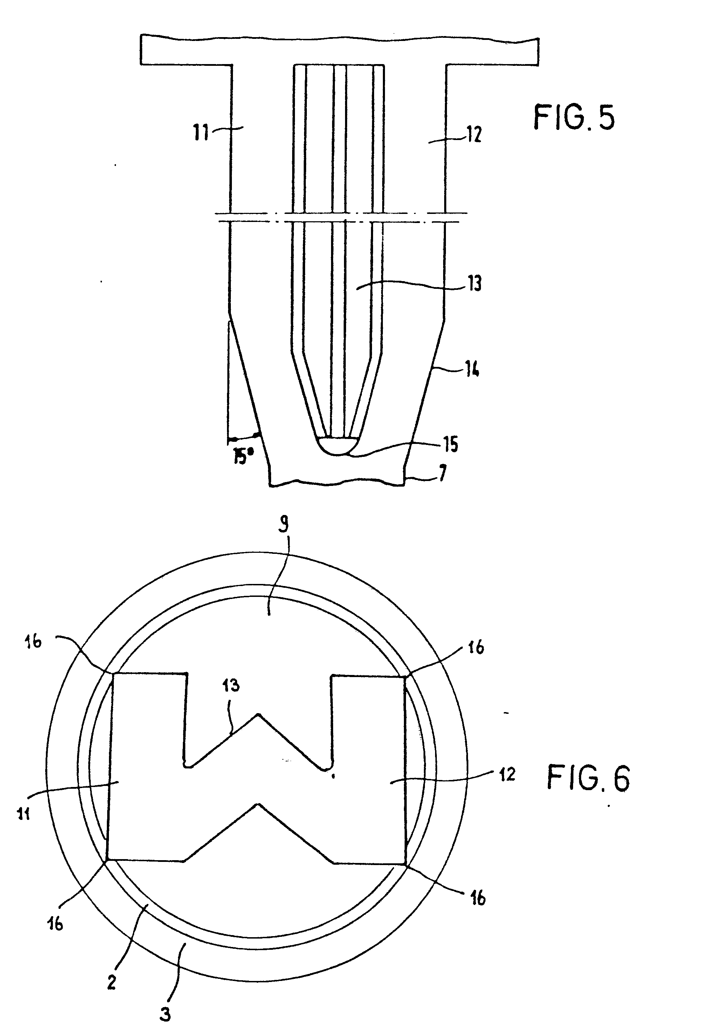

Wie der Fig. 5 entnehmbar ist, verläuft der Übergang 14 zwischen der Einpreßzone 6 und dem Pfosten 7 etwa konisch. Der Konuswinkel beträgt etwa 15°. Im Bereich des Überganges 14 kann sich der Steg 13 etwa keilförmig nach unten verjüngen. Er kann in einem Radius 15 enden. Ein rechteckiger Abschluß des Stegs 13 ist vorzuziehen. Die Fig. 6 zeigt die Verhältnisse der Einpreßzone 6 bei einem in eine Bohrung 9 eingesetzten Stift. Diese Bohrung weist Nennmaß auf. Beim Einpressen des Stiftes mit seiner Einpreßzone 6 in die Bohrung 9 durchdringen die Kanten 16 der äußeren schenkelförmigen Bereiche 11, 12 die Zinnschicht 2 der Bohrungswandung und treten in Kontakt mit der Kupferwandung 3 der Bohrung 9. Der Steg 13 wird hierbei elastisch deformiert. Eine elastische Deformation zeigen auch die äußeren Bereiche 11, 12, die jedoch geringer ist als diejenige des Stegs 13. Die elastische Verformung des Steges 13 und der äußeren Bereiche 11, 12 speichert mechanische Energie, die den notwendigen Kontaktdruck im Bereich der Kanten 16 erzeugt und dadurch eine zuverlässige Kontaktgabe garantiert. Der relativ große elastische Verformungsanteil gleicht die auftretenden Bohrungstoleranzen aus, wie später noch erläutert wird. Die vier Kanten 16 graben sich in die Zinnschicht 2 ein, berühren die Kupferhülse 3, die hierbei leicht deformiert, nicht jedoch durchschnitten wird. Hierbei sind die in der Leiterplatte 10 auftretenden inneren Spannungen relativ gering. Die Kontaktsicherheit ist durch die Speicherung der Energie im elastischen Bereich der Einpreßzone 6 wie auch der Bohrung 9 gegeben.

Bei der Ausführungsform nach Fig. 4 werden beim Zusammenpressen des Stegs 13 die oberen Schenkelenden der Bereiche 11, 12 nach außen geführt, jedoch infolge der Elastizität der Bereiche 11, 12 bei Kontakt mit der Bohrungswandung soweit zurückgeführt, daß der Abstand zwischen den oberen Kanten 16 etwa gleich demjenigen der unteren Kanten 16 in Fig. 6 ist.

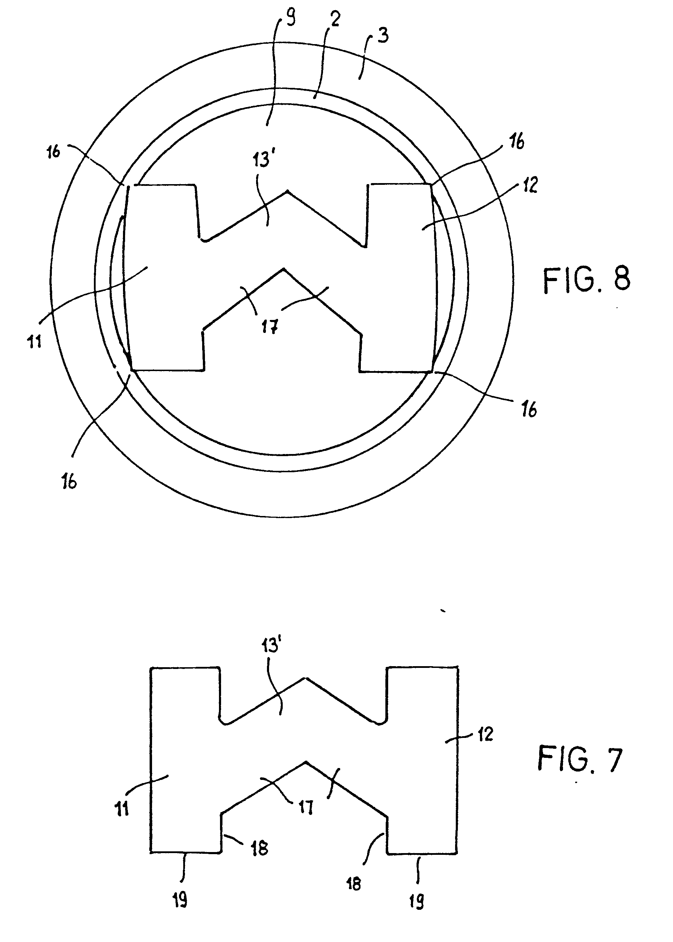

Bei der Ausführungsform nach Fig. 7 ist der Steg 13' ebenfalls V-förmig ausgebildet. Im Gegensatz zur Ausführungsform nach Fig. 4 beginnen die Schenkel 17 des Stegs 13' im Abstand 18 zu den Querkanten 19 der schenkelförmigen Bereiche 11, 12. Beiden Ausführungsbeispielen ist gemeinsam, daß die Schenkel 17 der Stege 13 bzw. 13' unter etwa 60° zu den balkenförmigen Bereichen 11, 12 verlaufen und zueinander etwa einen Winkel von etwa 120° einschließen. Die Stege 13 bzw. 13' sind gleich dick wie die schenkelförmigen Bereiche 11, 12, können jedoch auch dünner sein.

Wie vorstehend erwähnt, besteht beim Zusammenpressen des Stegs 13 nach Fig. 4 die Tendenz, daß die oberen Schenkelenden der Bereiche 11, 12 nach außen geführt werden, der Querschnitt der Einpreßzone also die Tendenz hat, eine W-Form anzunehmen. Daß beim eingepreßten Stift die M-Form im wesentlichen beibehalten wird, hat seinen Grund in der Elastizität der Bereiche 11, 12, die wie ein unten eingespannter und oben belasteter Träger wirken, der in Richtung der oberen Schenkelenden die Tendenz hat, sich der Wandung der Bohrung 9 anzupassen.

Bei der Ausführungsform nach Fig. 7 ist ebenfalls beim Zusammenpressen des Stegs 13' die Tendenz vorhanden, daß sich die oberen freien Schenkelenden der Bereiche 11, 12 nach außen biegen, der Querschnitt also im wesentlichen eine W-Form annimmt. Dadurch, daß der Ansatz der Schenkel 17 des V-förmigen Stegs 13' sich jeweils innen in der Mitte der Bereiche 11, 12 befindet, wirken diese Bereiche 11, 12 im eingepreßten Zustand wie ein mittig unterstützter Träger, der an beiden Enden, d. h. im Bereich der Kanten 16 belastet wird.

Wie der Fig. 8 zu entnehmen ist, greifen die Kanten 16 auch dann gleichmäßig in die Zinnschicht 2 ein, wenn die Bohrung 9 ein Übermaß aufweist. Beim Einpressen des Stiftes wird der Steg 13' elastisch deformiert, wobei der Winkel zwischen den Schenkeln 17 kleiner als 120° wird. Auch findet eine elastische Deformation der Bereiche 11, 12 statt, wobei die Deformation im jeweils oberen Teil geringer ist als im jeweils unteren Teil der Bereiche 11, 12.

Da hierbei die Bereiche 11, 12 wie ein mittig unterstützter Träger wirken, der im Bereich der Kanten 16 belastet ist, besteht bei der Außenkontur der Bereiche 11, 12 die bevorzugte Tendenz, sich der Innenkontur der Bohrung 9 anzupassen, was schon in Fig. 8 bei einer Bohrung 9 mit Übermaß sichtbar ist.

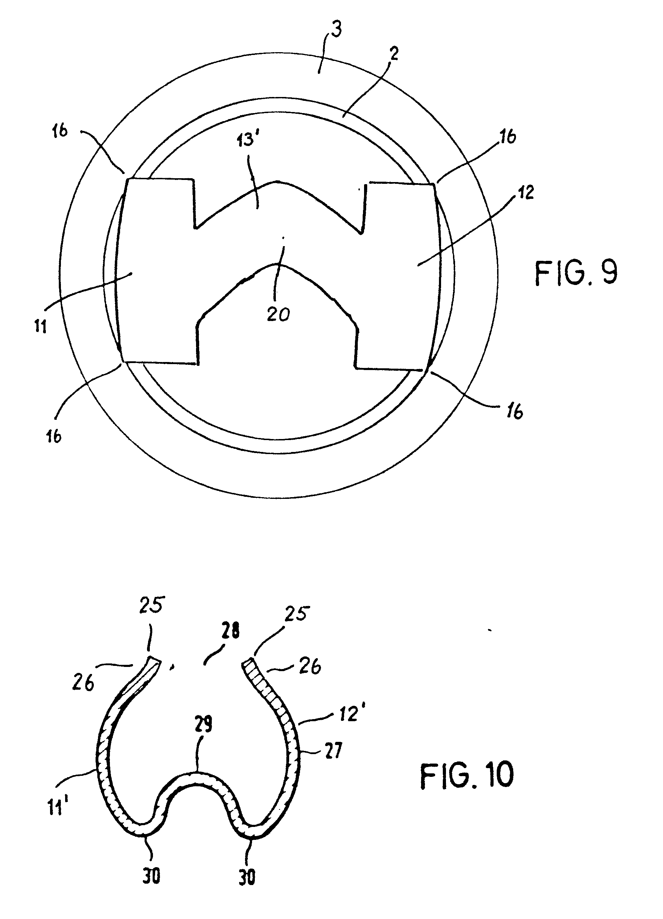

Wird der Stift mit einer Querschnittsform gemäß Fig. 7 in eine Bohrung 9 mit Untermaß gemäß Fig. 9 eingepreßt, dann wird im beschränkten Umfange der Schenkel 13' plastisch deformiert. Diese plastische Deformation findet in erster Linie im Grund 20 des V-förmigen Stegs 13' statt. Die Bereiche 11, 12 werden stark elastisch deformiert, wobei die Kanten 16 die Zinnschicht 2 völlig durchdringen und in die Kupferhülse 3 eindringen. Somit steht die gesamte Außenkontur der Bereiche 11, 12 in Kontakt mit der Zinnschicht 2 und an den Kanten 16 mit der Kupferhülse 3.

Bei den gezeigten beiden Ausführungsbeispielen ist die Dicke der Bereiche 11, 12 vorzugsweise gleich der Dicke des Stegs 13 bzw. 13'.

Bei gleicher Dicke von Steg 13 bzw. 13' und der äußeren Bereiche 11, 12 ist der Stift insbesondere geeignet zum Verbinden mehrerer Leiterplatten 10 über ihre jeweiligen Bohrungen 9. Gegebenenfalls kann hierbei der Steg 13 bzw. 13' dicker sein als die äußeren Bereiche 11, 12.

Wird dagegen der Stift in eine dünne Platte mit enger Bohrung eingesetzt, dann ist vorzuziehen, daß der Steg 13 bzw. 13' dünner ausgebildet ist als die äußeren Bereiche 11, 12.

Der vorbeschriebene Stift wird durch Prägen und Stanzen hergestellt.

Bei der Ausführungsform nach Fig. 7 hat es sich als günstig erwiesen, die Materialverdrängung der unteren V-förmigen Einprägung gleichzumachen wie die Materialverdrängung der oberen W-förmigen Einprägung, d. h. der Einprägungen, durch welche der Steg 13' gebildet wird.

Der Stift kann auch durch Biegen eines geschlitzten Rohres hergestellt werden. Die Fig. 10 zeigt einen Schnitt durch dessen Einpreßzone.

Das Rohr 27 weist einen Schlitz 28 auf, gegenüber dem eine halbkreisförmige Einprägung 29 vorgesehen ist, welche über die Verrundungen 30 in die äußeren schenkelförmigen Bereiche 11', 12' übergeht. Die halbkreisförmige Einprägung 29 zusammen mit den Verrundungen 30 entsprechen hierbei in ihrer Wirkung dem Steg 13 bzw. 13' der zuvor beschriebenen Ausführungsbeispiele. Die äußeren kreisbogenförmigen Bereiche 11' und 12' sind vergleichbar mit den äußeren Bereichen 11 und 12 der zuvor beschriebenen Ausführungsbeispiele.

Um ein Eingreifen bzw. Durchdringen der Zinnschicht 2 zu erhalten, sind die freien Enden der äußeren Bereiche 11', 12' nach außen aufgespreizt. Diese Aufspreizungen sind mit 26 bezeichnet. Hierdurch entsteht eine Kante 25, welche mit der Kante 16 der zuvor beschriebenen Ausführungsbeispiele vergleichbar ist.

**Patentansprüche**

1. Einpreßstift zum Herstellen einer lötfreien Verbindung mit der metallisierten Bohrung (9) mindestens einer Leiterplatte (10), wobei die Einpreßzone (6) des Stiftes zwei äußere Bereiche (11; 11', 12; 12') aufweist, die in Kontakt mit der Bohrungswandung (9) kommen und die über einen Steg (13; 13'; 29, 30) miteinander verbunden sind, welcher beim Einpressen des Stiftes in die Bohrung (9) deformiert wird, dadurch gekennzeichnet, daß die äußeren Bereiche (11; 11', 12; 12') etwa schenkelförmig mit je mindestens einer äußeren endseitigen Kante (16; 25') ausgebildet sind und der Steg (13; 13'; 29, 30) etwa V-förmig ausgebildet und elastisch deformierbar ist.

2. Einpreßstift nach Anspruch 1, dadurch gekennzeichnet, daß die äußeren Bereiche (11; 11', 12; 12') ebenfalls elastisch deformierbar ausgebildet sind.

3. Einpreßstift nach Anspruch 1 oder 2, dadurch gekennzeichnet, daß die äußeren Bereiche (11; 11', 12; 12') und der Steg (13; 13'; 29, 30) etwa gleich dick sind.

4. Einpreßstift nach einem der Ansprüche 1 bis 3, dadurch gekennzeichnet, daß der Winkel zwischen den Schenkeln (17) des Stegs (13, 13') etwa 120° beträgt.

5. Einpreßstift nach Anspruch 3 oder 4, dadurch gekennzeichnet, daß die Breite des Stegs (13; 13') zwischen den äußeren Bereichen (11, 12) etwa gleich der Gesamtdicke der äußeren Bereiche (11, 12) ist.

6. Einpreßstift nach einem der Ansprüche 1 bis 5, dadurch gekennzeichnet, daß die Schenkel (17) des Stegs (13') im Abstand zu den Querkanten (19) der äußeren Bereiche (11, 12) abgehen.

7. Einpreßstift nach Anspruch 6, dadurch gekennzeichnet, daß die Schenkel (17) etwa mittig von den äußeren Bereichen (11, 12) abgehen.

8. Einpreßstift nach Anspruch 5, dadurch gekennzeichnet, daß die Länge der äußeren Bereiche (11, 12) etwa dem 2,5fachen von deren Dicke ist.

9. Einpreßstift nach Anspruch 6 oder 7, dadurch gekennzeichnet, daß die Materialverdrängung bei den den V-förmigen Steg (13') erzeugenden Einprägungen jeweils etwa gleich groß ist.

10. Einpreßstift nach einem der Ansprüche 1 bis 3, dadurch gekennzeichnet, daß er aus einem geschlitzten Rohr (27) besteht, das gegenüber dem längsverlaufenden Schlitz (28) eine halbkreisförmige Einprägung (29) aufweist und bei dem die freien Enden der äußeren Bereiche (11', 12') nach außen gerichtete Aufspreizungen (26) aufweist.

11. Einpreßstift nach Anspruch 10, dadurch gekennzeichnet, daß die äußeren Bereiche (11', 12') kreisbogenförmig ausgebildet sind.

12. Einpreßstift nach Anspruch 10 oder 11, dadurch gekennzeichnet, daß zwischen der Einprägung (29) und den äußeren Bereichen (11', 12') Verrundungen (30) vorgesehen sind.

## Claims

1. Press-in pin for producing a solderless connection with the metallised bore (9) of at least one printed circuit board (10), whereby the press-in zone (6) of the pin has two outer areas (11; 11'; 12; 12') which come into contact with the bore wall (9) and are connected to one another via a cross-piece (13; 13'; 19, 30), which is deformed when the pin is pressed into the bore (9), characterised in that the outer areas (11; 11'; 12; 12') are roughly shaped as shanks, each with at least one outer end edge (16; 25') and the cross-piece (13; 13'; 29, 30) is constructed as a rough V shape and is elastically deformable.

2. Press-in pin according to claim 1, characterised in that the outer areas (11; 11'; 12, 12') are also elastically deformable.

3. Press-in pin according to claim 1 or 2, characterised in that the outer areas (11; 11'; 12; 12') and the crosspiece (13; 13'; 29, 30) are of approximately the same thickness.

4. Press-in pin according to one of claims 1 to 3, characterised in that the angle between the shanks (17) of the cross-piece (13; 13') is approximately 120°.

5. Press-in pin according to claim 3 or 4, characterised in that the width of the cross-piece (13, 13') between the outer areas (11, 12) is approximately the same as the total thickness of the outer areas (11, 12).

6. Press-in pin according to one of claims 1 to 5, characterised in that the shanks (17) of the cross-piece (13') begin at a certain distance from the transversal edges (19) of the outer areas (11, 12).

7. Press-in pin according to claim 6, characterised in that the shanks (17) leave the outer areas (11, 12) roughly in the centre.

8. Press-in pin according to claim 5, characterised in that the length of the outer areas (11, 12) is roughly 2.5 times their thickness.

9. Press-in pin according to claim 6 or 7, characterised in that the removal of material is roughly the same size with each of the stamping operations producing the V-shaped cross-piece (13').

10. Press-in pin according to one of claims 1 to 3, characterised in that it consists of a split tube (27) comprising a semi-circular stamped part (29) opposite the longitudinal slit (28) and in which the free ends of the outer areas (11', 12') are splayed outwards (26).

11. Press-in pin according to claim 10, characterised in that the outer areas (11', 12') are circular.

12. Press-in pin according to claim 10 or 11, characterised in that between the stamped part (29) and the outer areas (11', 12') are provided rounded areas (30).

## Revendications

1. Broche à enfoncer pour la réalisation d'une liaison sans soudure avec les trous métallisés (9) d'au moins une plaque conductrice (10), où la zone d'enfoncement (6) de la broche présente deux régions extérieures (11, 11'; 12, 12') qui viennent en contact avec les parois des trous (9) et qui sont reliées l'une à l'autre par une âme (13, 13', 29, 30), âme qui est déformée lors de l'enfoncement de la broche dans les trous (9), caractérisée en ce que les régions extérieures (11, 11'; 12, 12') sont conformées en présentant au moins une arête terminale extérieure (16; 25') et en ce que l'âme (13, 13', 29, 30) est réalisée en forme de V et est déformable élastiquement.

2. Broche à enfoncer suivant la revendication 1, caractérisée en ce que les régions extérieures (11, 11'; 12, 12') sont également réalisées déformables élastiquement.

3. Broche à enfoncer suivant la revendication 1 ou 2, caractérisée en ce que les régions extérieures (11, 11'; 12, 12') et l'âme (13, 13', 29, 30) ont à peu près même épaisseur.

4. Broche à enfoncer suivant l'une des revendications 1 à 3, caractérisée en ce que l'angle entre les branches (17) de l'âme (13, 13') est d'environ 120°.

5. Broche à enfoncer suivant la revendication 3 ou 4, caractérisée en ce que la largeur de l'âme (13, 13') entre les régions extérieures (11, 12) est à peu près égale à l'épaisseur totale des régions extérieures (11, 12).

6. Broche à enfoncer suivant l'une des revendications 1 à 5, caractérisée en ce que les branches (17) de l'âme (13') s'écartent à distance des arêtes transversales (19) des régions extérieures (11, 12).

7. Broche à enfoncer suivant la revendication 6, caractérisée en ce que les branches (17) s'écartent à peu près centralement des régions extérieures (11, 12).

8. Broche à enfoncer suivant la revendication 5, caractérisée en ce que la longueur des régions extérieures (11, 12) est égale à environ 2,5 fois leur épaisseur.

9. Broche à enfoncer suivant la revendication 6 ou 7, caractérisée en ce que la compression de la matière dans les déformations provoquées par impression, engendrant l'âme (13') en forme de V est chaque fois à peu près de même grandeur.

10. Broche à enfoncer suivant l'une des revendications 1 à 3, caractérisée en ce qu'elle est faite d'un tube fendu (27) qui présente, en face de la fente (28) s'étendant longitudinalement, une déformation provoquée par impression (29), en forme de demi-cercle, et où les extrémités libres des régions extérieures (11', 12') présentent des évasements (26) dirigés vers l'extérieur.

11. Broche à enfoncer suivant la revendication 10, caractérisée en ce que les régions extérieures (11', 12') sont réalisées en forme d'arcs de cercle.

12. Broche à enfoncer suivant la revendication 10 ou 11, caractérisée en ce qu'entre la déformation provoquée par impression (29) et les régions extérieures (11', 12') sont prévus des arrondis (30).

FIG. 1

FIG. 2

FIG. 3

FIG. 4

FIG. 5

11

12

13

14

15

7

15°

FIG. 6

9

16

16

13

11

12

16

16

2

3

9

FIG. 8

FIG. 7

FIG. 9

FIG. 10